# EUROPEAN PATENT SPECIFICATION

(11) **EP 4 359 585 B1**
(45) Date of publication and mention of the grant of the patent: **02.07.2025**
(21) Application number: 22850471.8
(22) Date of filing: 26.07.2022
(51) Int. Cl.: C23C 16/448, C23C 16/455, C23C 16/52

(54) **MULTIPLE ZONE HEATED ENCLOSURE FOR OPTIMIZED SUBLIMATION OF SOLID-PHASE PRECURSORS**
MEHRZONEN-ERHITZUNGSGEHÄUSE ZUR OPTIMIERTEN SUBLIMATION VON FESTPHASENVORLÄUFERN
ENCEINTE CHAUFFÉE À ZONES MULTIPLES POUR SUBLIMATION OPTIMISÉE DE PRÉCURSEURS EN PHASE SOLIDE

(30) Priority: 30.07.2021 US 202163227842 P
(43) Date of publication of application: 01.05.2024
(73) Proprietor: Versum Materials US, LLC, Tempe, AZ 85284 (US)
(72) Inventor: PILTZ, Thomas W., TEMPE, Arizona 85284 (US); SEIDEL, Mason, TEMPE, Arizona 85284 (US); ESCHBACH, Robert, TEMPE, Arizona 85284 (US); BAILEY, Wade Hampton, TEMPE, Arizona 85284 (US); EBELING, David B., TEMPE, Arizona 85284 (US); FATIMA, Syedah Yusra, TEMPE, Arizona 85284 (US); RIDER, David M., TEMPE, Arizona 85284 (US); CABLE, Shawn S., TEMPE, Arizona 85284 (US)
(74) Representative: Sommer, Andrea
(86) International application number: PCT/US2022/074140
(87) International publication number: WO 2023/010001

(56) References cited:
- WO-A1-2021/145736
- KR-A- 19980 044 283
- KR-A- 20170 126 536
- KR-A- 20200 113 533
- KR-A- 20210 093 032
- KR-B1- 101 615 913
- US-A1- 2005 019 504
- US-A1- 2017 159 207

## Description

### CROSS-REFERENCE TO RELATED APPLICATIONS

This application claims the benefit of US Provisional Patent Application having serial number 63/227,842 filed on July 30, 2021.

### TECHNICAL FIELD

The present disclosure relates generally to chemical delivery systems and, more particularly, to a chemical delivery system that uses heated enclosures that have been optimized for the sublimation of solid-phase semiconductor process materials and subsequent delivery of the resultant vapor.

### BACKGROUND OF THE DISCLOSURE

Chemical delivery systems, such as those commonly used in the manufacture of semiconductors, often require heating process materials in order to meet pressure and flow requirements of the equipment located downstream. In some cases, the heating is necessary to support and maintain a phase change from either a liquid to a vapor (vaporization) or from a solid to a vapor (sublimation). If a process material reverts back to its previous phase, the process delivery line will not sustain the required delivery conditions, resulting in process variation, yield loss, or even interruption to the process itself. This is particularly important when working with process materials that undergo sublimation. The phase change from vapor back to solid can result in the deposited material clogging the process line. Clogged lines can be very difficult and time-consuming to clear.

In order to maintain the preferred vapor phase, the temperature and pressure conditions along the entire process material delivery line must be carefully monitored and controlled. For most chemical delivery systems, this often means elevating the temperature of the source container by using mechanisms such as a resistive electrical or inductive heater. The process lines interconnecting the source container and the downstream process tools are then heated using a heat trace attached directly to the piping and piping components in the process line.

The heat trace, an electrical resistive heating wire, typically is wrapped around each pipe and pipe component for the purposes of providing heat to them. Over the wire, one or more layers of insulative tape is or are typically wrapped to prevent the heat from dissipating to the ambient environment. If a repair needs to be made to a pipe and pipe component, the heat trace must be unwrapped and removed. Although a heat trace is effective and reliable if not disturbed, upon removing it, the wire is often broken and must be replaced. The heat trace and the insulation layer installed over the heat trace require much labor and time to: install during the original manufacture, uninstall for repairs, and reinstall after performing a repair. There is a need to maximize the uptime of all of the tools used in semiconductor manufacturing, including the systems that supply them with the necessary gases and chemicals for manufacture; therefore, there is a need to increase the uptime of all systems that supply gas and chemicals to the tools. In addition, there is a need to decrease the footprint for delivery systems, caused by increasing numbers and sizes of pipes, pipe components, and chemical delivery cabinets in a given space.

Chemical vapor deposition (CVD) is a process in which a deposition surface (i.e., a substrate such as a silicon wafer) is contacted with vapors of volatile chemical compounds, generally at elevated temperatures. The compounds, or CVD precursors, are reduced or dissociated at the deposition surface, resulting in an adherent coating of a preselected composition, in a deposition chamber. A precursor for use in a CVD process can be stored in gaseous, liquid, or solid form in a source container. The use of a solid precursor is especially challenging in terms of sublimating and subsequently transporting the precursor vapor to the substrate. Other more general concerns when designing a CVD system include a desire to minimize downtime of the system and the limited space available near the process tool that applies the precursor. Accordingly, it is desirable to provide a chemical delivery system that addresses these challenges. Specifically, it is desirable to provide a chemical delivery system that efficiently, effectively, and consistently delivers a solid precursor in a CVD process while minimizing downtime of the CVD system and the amount of space taken up near the process tool.

As the use of solid-phase CVD precursors becomes increasingly common, the number of processes that require high-temperature (over 150°C) is also increasing. At these temperatures, traditional heating methods for both the source container and the process lines may not be feasible due to the lack of appropriate temperature rating, insufficient heating power, or physical space constraints. Artisans have offered a variety of solutions.

U.S. Patent No. 7,437,060 relates to a system for delivering a controlled and stable vapor flow of vaporized liquid and solid source materials for use in CVD and ion implantation processes. The system has particular utility for semiconductor manufacturing applications. U.S. Patent Application Publication No. 2019/0177840 is directed to a chemical delivery system, particularly a chemical delivery system for delivering precursors during a CVD process. U.S. Patent No. 7,204,885 relates to CVD and, in particular, to methods for CVD including preheating of the CVD precursors, systems to perform the methods, and apparatus produced by such methods. U.S. Patent Application Publication No. 2019/0368039 teaches Group VI transition metal-containing film-forming compositions useful for deposit on substrates via vapor deposition processes. U.S. Patent Application Publication No. 2019/0284684 discloses a sublimated gas supply system for supplying a sublimated gas of a solid material to a post process (for example, a film-forming process) and a sublimated gas supply method.

U.S. Patent No. 6,953,047 teaches an apparatus for storing and delivering a low vapor pressure process chemical to a process tool for semiconductor fabrication. The apparatus includes: (a) a bulk container for storing the process chemical; (b) a process container for delivering the process chemical to the process tool; (c) a first manifold for delivering process chemical from the bulk container to the process container; (d) a solvent container storing a quantity of solvent; and (e) a second manifold for delivering the process chemical from the process container to a process tool. A process for using the apparatus is also contemplated. The Korean patent application KR 10-2017-0126536 discloses a deposition apparatus for the deposition of thin films by evaporating the material to be deposed in the surface of a deposition target. The deposition apparatus comprises a deposition source assembly which is a box comprising two crucibles (111, 121) and one heater (151, 152) and one nozzle unit (112, 122) for each crucible and an insulating member (160) between the crucibles, the nozzle units leading to the outside of the deposition source assembly 101 to the deposition target.

One approach to addressing the needs and challenges identified above is to use heated enclosures in lieu of container heaters and heat traces. Heated enclosures have the advantage of blanketing the entire contents at a controlled temperature that can exceed the capabilities of the traditional heating methods. In the case of this disclosure, several additional design elements are incorporated into the design of a source or process container oven that result in optimized performance for the delivery of sublimated vapor from solid-phase precursor.

### BRIEF SUMMARY OF THE DISCLOSURE

To meet these and other needs and challenges, and in view of its purposes, the present disclosure provides a heated enclosure as described in the appended claims.

The embodiments of the invention can be used alone or in combinations with each other.

### BRIEF DESCRIPTION OF THE DRAWING

The disclosure is best understood from the following detailed description when read in connection with the accompanying drawing. It is emphasized that, according to common practice, the various features of the drawing are not to scale. On the contrary, the dimensions of the various features are arbitrarily expanded or reduced for clarity. Included in the drawing are the following figures:
FIG. 1 is a perspective front view of the oven according to one embodiment of the present invention;
FIG. 2 a perspective top view of the oven shown in FIG. 1

### DETAILED DESCRIPTION OF THE DISCLOSURE

The following detailed description provides preferred exemplary embodiments only, and is not intended to limit the scope, applicability, or configuration of the invention. Rather, the following detailed description of the preferred exemplary embodiments will provide those skilled in the art with an enabling description for implementing the preferred exemplary embodiments of the invention

For purposes of the present specification and accompanying claims, the term ""predetermined" means determined beforehand, so that the predetermined characteristic must be determined, i.e., chosen or at least known, in advance of some event. For purposes of the present specification and accompanying claims, the term "piping" refers to one or more structures through which fluids can be transported between two or more components of a system. For example, pipes can include conduits, ducts, manifolds, and combinations thereof that transport liquids and/or gases at varying pressures throughout a system.

For purposes of the present specification and accompanying claims, the term "fluid flow communication" refers to the nature of connectivity between two or more components that enables liquids and/or gases to be transported between the components in a controlled fashion. Coupling two or more components such that they are in fluid flow communication with each other can involve any suitable method known in the art, such as with the use of flanged conduits, gaskets, and/or bolts.

As used in this document, the terms "about," "approximately," and "substantially" are intended to correspond to ± 5% of the stated value or parameter (e.g., extending in a zero degree plane or flat). The terms "attached" and "affixed" mean that two components are joined, fastened, or connected to each other, whether directly or indirectly (through an intervening component).

The terms "a" and "an" and "the" and similar referents as used in the context of describing the invention (especially in the context of the following claims) are to be construed to cover both the singular and the plural, unless otherwise indicated herein or clearly contradicted by context. The terms "comprising," "having," "including," and "containing" are to be construed as open-ended terms (i.e., meaning "including, but not limited to") unless otherwise noted. Recitations of ranges of values are merely intended to serve as a shorthand method of referring individually to each separate value falling within the range, unless otherwise indicated herein, and each separate value is incorporated into the specification as if it were individually recited herein. All methods described in this document can be performed in any suitable order unless otherwise indicated or otherwise clearly contradicted by context. The use of any and all examples, or exemplary language (e.g., "such as") is intended merely to better explain the invention and does not pose a limitation on the scope of the invention unless otherwise claimed. No language in the specification should be construed as indicating any non-claimed element as essential to the practice of the invention. The use of the term "comprising" in the specification and the claims includes the narrower language of "consisting essentially of" and "consisting of."

Embodiments are described, including the best mode known to the inventors for carrying out the invention. Variations of those embodiments may become apparent to those of ordinary skill in the art upon reading the following description. The inventors expect skilled artisans to employ such variations as appropriate.

It is often necessary to distribute a chemical to a series of points of use located within an industrial facility. For instance, in a semiconductor manufacturing facility, liquid chemicals such as photoresist, slurries, hydrofluoric acid, hydrogen peroxide, ammonium hydroxide, and the like are distributed to various tools used in the manufacture of the semiconductors. Similarly, gas-phase chemicals such as hydrogen fluoride, nitrogen trifluoride, and anhydrous ammonia also may require distribution in this manner. Typically, a source unit, which can be one or more pumps, chemical containers, or pressure containers, induces fluid flow through a process delivery system having a series of valve manifolds that are used to connect groups of tools to the delivery system. Sometimes it is necessary or beneficial to heat the pipes, valves, and containers that are used in the system to improve the flow of the fluids conducted in the system, especially if the fluid is viscous at lower temperatures and/or if room temperature is at or near the temperature that the fluid changes to (or from) the desired delivery phase of matter. The present disclosure addresses the need to provide such heat.

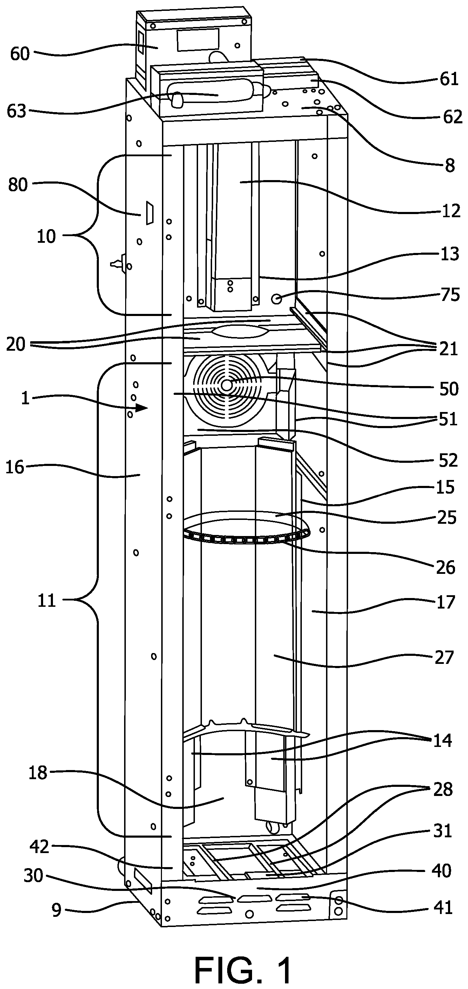

Referring now to the drawing, in which like reference numbers refer to like elements throughout the various figures that comprise the drawing, Fig. 1 shows an improved multiple zone heated enclosure or oven 1. The oven 1 provides optimized sublimation of the solid-phase semiconductor process materials typically used in semiconductor manufacturing, and subsequent delivery of the resultant vapor of the solid-phase semiconductor process materials. A combination of features maximizes the performance of the oven 1 in the areas of heat-up, cool-down, and process material delivery capacity, safety, and serviceability.

The oven 1 has a top 8, a bottom 9, a pair of side walls each defined by a side exterior wall 16 and a corresponding side interior wall 17, and a back interior wall 18 - all of which, in combination, define a hollow housing. The oven 1 is approximately a rectangle in shape, as illustrated in FIG. 1, although other housing shapes are possible, including generally cubic, spherical, or ovoid shapes or irregular shapes. A reversible oven door (not shown) is attached to the exterior walls 16 and can be opened (to allow access to the components within the interior of the housing) or closed (to protect those components and to retain heat within the oven 1). Preferably, the door has self-closing hinges and triple-mounted compression latches.

One or more of the top 8, the bottom 9, the side walls, the back interior wall 18, and the door is or are provided with insulation to better retain heat within the oven 1. Preferably, all of these components, which form the body of the housing, are insulated. The insulation provided in the top 8, the bottom 9, the side walls, the back interior wall 18, and the door may be, for example, commercial, household oven insulation about 2 inches (5 cm) thick. To better retain heat within the oven 1, the thickness of the insulation in the door may be thicker (e.g., about 2.75 inches or 7 cm) than the thickness of the insulation elsewhere. A more extensive description of suitable insulation is provided below.

The oven 1 has dual, independent heated zones with independent temperature controls and dedicated overtemperature protection. Thus, as depicted in FIG. 1, the oven 1 has an upper heated zone 10 and a lower heated zone 11. By "independent" is meant that the upper heated zone 10 can be controlled to have a temperature separate and apart from the controlled temperature in the lower heated zone 11 (and vice versa). Temperature control is a process in which the change of temperature of a space (and objects collectively within that space) is measured or otherwise detected and the passage of heat energy into or out of the space is adjusted to achieve a desired temperature. A temperature controller takes an input from a temperature sensor and has an output that is connected to a control element such as a heater or fan. The temperature controller compares the actual temperature to the desired control temperature, or setpoint, and provides an output to the control element.

Overtemperature protection in a power supply is a protection system that shuts down the power supply when the internal temperature in the upper heated zone 10 or the lower heated zone 11 exceeds a predetermined value. A circuit is used to monitor and generate a trigger signal that starts the shutdown process at undesirable high temperature. High temperatures may be developed due to various factors such as faulty components, overloading, over voltage at the supply, a malfunctioning cooling system, blocked ventilation, or other factors that stress the components.

The upper heated zone 10 and the lower heated zone 11 are separated or divided by a removeable and adjustable divider plate 20. The divider plate 20 is a substantially flat, smooth, relatively thin component made of a durable material capable of withstanding the elevated temperatures within both the upper heated zone 10 and the lower heated zone 11. The divider plate 20 is sized to fit snugly within the oven 1, contacting and extending among the side interior walls 17, the back interior wall 18, and the door. Therefore, for a rectangular-shaped oven 1, the divider plate 20 is rectangular.

The divider plate 20 can be inserted into and removed from the oven 1 along guide rails 21. Typically, a pair of guide rails 21 are provided, one on each of the side interior walls 17. Another pair of guide rails 21 could also be provided, however, on the back interior wall 18. Different sets of guide rails 21 could be provided at different heights within the oven 1 so that the user has options when inserting the divider plate 20 and the height of the divider plate 20 can be adjusted. Typically, the guide rails 21 are affixed to the walls. Alternatively, a single set of guide rails 21 could slide up and down within the oven 1 along tracks and could be locked at a desired height by a locking mechanism.

The ability to adjust the height of the divider plate 20 within the oven 1 achieves functional advantages. Such adjustability is helpful, for example, to define the spaces within the upper heated zone 10 and the lower heated zone 11. It is also helpful to account for height differences in the cylinders placed in the oven 1. Thus, the divider plate 20 can be adjusted to allow for full movement of the container (typically a cylindrical tank storing a precursor material) when the container is installed into or removed from the oven 1. When adjusted into its predetermined position within the oven 1, the divider plate 20 also functions to provide additional bracing for the container while the container is in place within the oven 1.

It is possible, of course, that multiple divider plates 20 may be provided rather than just one divider plate 20. The multiple divider plates 20 could divide the oven 1 into more than two heated zones. It would be within the knowledge of an artisan to predetermine the number of divider plates 20 required to best meet the needs of a particular application. The use of multiple (two or more) independent heated zones within the oven 1 functions to maximize warm-up performance of the oven 1, prevent damage to the valves installed on the process container, and maintain a temperature differential during normal operation that reduces the risk that a process line could become clogged with re-deposited process material.

Heat is independently provided to each of the upper heated zone 10 and the lower heated zone 11 by using separate heaters. Thus, a heater 12 is provided to heat the upper heated zone 10 and a separate heater 14 is provided to heat the lower heated zone 11. The heater 12 and the heater 14 may be identical, or different, heating devices depending upon the application. Generally, the heater 12 and the heater 14 may be any device that produces and radiates heat, functioning to raise the temperature of a space (i.e., the upper heated zone 10 and the lower heated zone 11). Any one of several heating methods could be utilized, including a single heater having independent zones.

As shown in FIG. 1, the heater 12 may comprise a single, unitary element and the heater 14 may comprise more than one element (two elements are depicted). The number of elements that comprise the heater 12 and the heater 14 can be selected to accommodate the heating needs of the upper heated zone 10 and the lower heated zone 11 for different applications.

Regardless of its number of elements, the heater 12 is attached to the oven 1 within the upper heated zone 10. Conventional attachment mechanisms are suitable. An example attachment mechanism is a mounting bracket 13 that is affixed permanently to one or more of the side interior walls 17 and the back interior wall 18. Similarly, the heater 14 is attached to the oven 1 within the lower heated zone 11 using one or more mounting brackets 15.

Portions of the heater 14 may be covered by a heat shield 27 that is constructed of a durable and thermally conductive material capable of withstanding temperatures in excess of 200°C, such as stainless steel. The positioning of the heat shield 27 serves to delocalize the thermal impact of the heater 14 on the source or process container (not shown). By leaving portions of heater 14 uncovered by heat shield 27, the temperature of surface of the source or process container in front of the uncovered heater 14 can be selectively increased by 20°C or more.

The source or process container (not shown) is placed within the oven 1, typically within the lower heated zone 11 given the weight of the container and position of other components such as piping. When the container is damaged or empty and needs to be replaced or re-filled, or when a container storing a different material is desired, the door is opened to provide access to the container and the container is removed from the oven 1. The same or a different container can be re-inserted or inserted, as the case may be, into the oven 1 and the door subsequently closed.

The container is retained within the oven 1 using any of a number of attachment mechanisms known to an artisan. A suitable attachment mechanism is the combination of a container mounting bracket 25 and a tie-down chain 26. The tie-down chain 26 can be a rope, cable, or strap able to fasten or secure the container within the oven 1 and prevent shifting or other movement of the container during use. Optionally, a binder can be provided to tighten the die-down chain 26 by pulling slack out of the tie-down chain.

The container sits on a weighing scale 30 located within a scale chamber 40 proximate or near the bottom 9 of the oven 1. The scale 30 supports and measures the weight or mass of the container and, therefore, allows determination of the amount of product remaining in the container. The scale 30 has an insulated scale platform 31 on which the container directly sits. The scale platform 31 is preferably an integral part of the scale 30. (By "integral" is meant a single piece or a single unitary part that is complete by itself without additional pieces, i.e., the part is of one monolithic piece formed as a unit with another part.) Because the scale platform 31 is insulated and sized to accommodate almost the entire footprint of the oven 1, the scale platform 31 substantially insulates the scale chamber 40 from the heated zones 10, 11 located above the scale chamber 40. Thus, the scale 30 is thermally protected.

The scale chamber 40 forms an antechamber or sump in the bottom of the oven 1. The scale chamber 40 is ventilated to protect personnel as well as to cool the scale 30. Ventilation can be achieved by any suitable mechanism or mechanisms. As illustrated in FIG. 1, the scale chamber 40 has a plurality of ventilation inlets 41 (which may be louvers) located in the front of the scale chamber 40 (under the door) and one or more ventilation ports 42 located in the side wall or walls of the oven 1. Not visible in FIG. 1 is a ventilation duct located in the portion of the back interior wall 18 that partially forms the scale chamber 40. (A "portion" is a part of any whole, either separated from or integrated with it.) In addition to cooling the scale 30, one or more of the ventilation inlets 41, the ventilation ports 42, and the ventilation duct allow leak detection. (Leaks from components located within the oven 1, such as the container and connections to the container, are deposited in the bottom of the oven 1 which thereby serves to contain the leakage.)

Ventilation and air circulation are important not only in the scale chamber 40 but in the heated zones 10, 11. Proper ventilation and air circulation help to abate, and protect personnel from, hazardous vapor-phase process materials. Therefore, the oven 1 includes components that facilitate ventilation and air circulation in the scale chamber 40 located in the bottom of the oven 1, in the heated zone 12 located in the top of the oven 1, and in the heated zone 11 located between the scale chamber 40 and the heated zone 12. The components that facilitate ventilation and air circulation in the scale chamber 40 are discussed above.

The scale platform 31 may have multiple elevation rails 28 constructed of a durable material such as stainless steel affixed to its top surface via welding or removable hardware such as screws. The elevation rails 28 serve to minimize the contact area between the process or source container (not shown) and the scale platform 31. This application has the positive effect of reducing the thermal loss from the process or source container into the scale platform 31. It also allows circulated air to contact the underside or the process or source container. This increases the rate of thermal transfer into the container during heating operations and increases the rate of thermal transfer out of the container during cooling operations.

Turning to the components located in the heated zone 11 that facilitate ventilation and air circulation, a circulation fan 50 is provided. The circulation fan 50 draws air from an inlet and directs air toward one or more outlets 51. Thus, the circulation fan 50 circulates airflow around the oven 1 for maximized convective heat transfer. The circulation fan 50 may be ducted through the heater mounting brackets 15 to direct air downward toward the floor on which the oven 1 sits. Access to the circulation fan 50 from the interior of the oven 1 is facilitated by an access panel 52. Such access permits maintenance of the circulating fan 50 and allows the circulating fan 50 to be removed from the oven 1 through the front of the oven 1 when the door is open.

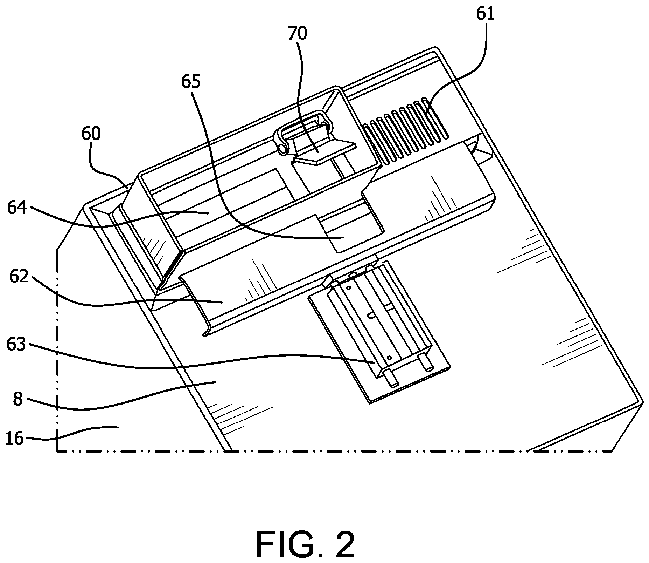

As highlighted in FIG. 2, ventilation and fresh air are provided to the upper heated zone 12 through the top 8 of the oven 1. A raised exhaust inlet 60 extends upward from the top 8 proximate (adjacent as illustrated) to a fresh air inlet 61. The exhaust inlet 60 surrounds both an aperture 64, which provides access to the interior of the oven 1 (i.e., to the upper heated zone 10), and a pressure relief flap valve 70. The pressure relief flap valve 70 provides overpressure protection by preventing the buildup of pressure within the oven 1 in case of a leak while heating is active.

A single exhaust blast gate 62 is provided to selectively and simultaneously cover both the fresh air inlet 61 and the aperture 64. Thus, the exhaust blast gate 62 covers the fresh air inlet 61 and the aperture 64 when the exhaust blast gate 62 is closed and leaves uncovered the fresh air inlet 61 and the aperture 64 when the exhaust blast gate 62 is in its open position (as illustrated in FIGS. 1 and 2). A notch 65 in the exhaust blast gate 62 allows access to the pressure relief flap valve 70 even when the exhaust blast gate 62 is closed.

An exhaust blast gate actuator 63 allows for selective opening and closing of the exhaust blast gate 62. Preferably, the exhaust blast gate actuator 63 is a pneumatic linear actuator with dual feeds. In combination, the components that provide ventilation and fresh air to the upper heated zone 12 through the top 8 of the oven 1 permit control of the exhaust and fresh air within the oven 1. Such control allows for minimization of thermal losses while heating is active as well as reducing the time required to cool the oven 1 down to ambient temperature for access or maintenance.

The portion of the back interior wall 18 that partially forms the scale chamber 40, the portion of the back interior wall 18 that partially forms the lower heater zone 11, or the portion of the back interior wall 18 that partially forms the upper heater zone 12 may be formed, in its entirely or in part, as a false wall. In alternative embodiments, two or all three of the portions could have false walls. It would also be possible, of course, to locate a false wall in one or both of the side walls.

A false wall facilitates the flow of fresh air and ventilation. By locating the circulation fan 50 close to the false wall portion of the back interior wall 18, for example, the false wall fresh air inlet will help with cooldown times. A false wall is an effective way to screen off an area from view. Because the primary purpose of a false wall is to obscure an area from view, the false wall does not need to be load-bearing and is simpler to construct than ordinary partition walls.

Access ports may be provided in various locations in the oven 1. For example, an access port 75 can be located in the back interior wall 18 and in the upper heated zone 10. Such access ports accommodate process piping, thermocouples, and other external structures as well as providing increased circulation among different areas of the oven interior. The access ports, and other components such as a reversible oven door, allowing the oven 1 to be installed in multiple configurations within a larger delivery system. Among the access ports is an interconnecting passthrough 80. As illustrated in FIG. 1, the interconnecting passthrough 80 is formed by a first opening in one side wall and a second opening (preferably at the same height as the first opening) in the second side wall opposite the first side wall. Typically, the interconnecting passthrough 80 is located at about the center of the width of each side wall for structural support.

Often it is desirable in a delivery system with multiple product containers and automated crossover capabilities to use multiple ovens 1 in combination. In one embodiment, such a system would be configured with multiple ovens 1 connected by a common valve manifold heated enclosure (not shown). This configuration allows for the individual container heated enclosures to be independently brought online and offline. The replacement of depleted source containers is completed at ambient temperature while the other container heated enclosures are kept at operating temperature, thus providing a continuous supply of process material. The common valve manifold heated enclosure stays at operating temperature throughout, because any drop in temperature could result in undesired phase changes of the process material. It is common practice to keep the temperature of a downstream heated zone slightly higher than that of the previous heated zone. This minimizes the possibility of undesired phase change in the process material.

Any void remaining in the inter-chamber piping passthrough between the heated enclosures is filled with a compressible insulator such as silicon rubber. The insulator not only directs the heat towards any interconnecting piping, it also serves as a thermal barrier when the upstream heated enclosure is at ambient temperature such as during a source container changeout.

As described above, one or more layers of a thermal insulative material cover a majority of the surface area of the components used in the oven 1. The one or more layers of insulation can be attached with mechanical fasteners. In any method, the step of attaching the one or more layers of insulation may be free of adhesives. Insulation when used in this document means thermal insulation, which may also include heat reflective materials if desired.

The one or more layers of insulation (a) may comprise insulation board and/or insulation attached to a plastic cover and/or an insulated jacket made of flexible insulating material; and/or (b) is or are custom-fabricated to form-fit over the components and/or is or are shaped to provide a heated air volume towards the center of the component on which the insulation is mounted. The one or more layers of insulation in any embodiment may be removably attached to a component using fasteners selected from bolts, screws, clamps, cable ties, magnets, adhesives, zippers, snaps, clasps, bungee cords, hook-and-eye, hook-and-loop (such as Velcro^{®}) strips, or the like.

Velcro is the brand name of the first commercially marketed fabric hook-and-loop fastener sold by Velcro USA, Inc. of Manchester, New Hampshire. The fastener was invented by George de Mestral. See U.S. Patent No. 3,009,235. Hook-and-loop fasteners consist of two components: typically, two lineal fabric strips or tapes (alternately round dots or squares) which are attached (e.g., sewn, adhered, etc.) to the opposing surfaces to be fastened. The first component features tiny hooks (e.g., the hook tape); the second features even smaller and "hairier" loops (e.g., the loop tape). When the two surfaces are pressed together, the hooks catch in the loops - and the two pieces fasten or bind temporarily. When separated, by pulling or peeling the two surfaces apart, the Velcro strips make a distinctive "ripping" sound.

The insulation may comprise one of more pieces of insulation board or foam. The insulation may be rigid sheets, such as rigid foam or board, that are cut to cover at least the majority of the heat-conductive component. The insulation would also be cut or formed to allow the passage therethrough of the component as is known to a person of ordinary skill in the art. Alternatively, or additionally, the insulation board or foam may be formed or cut to form-fit at least some of the components. Additional layers of insulation may be added on top of one or more layers of insulation, at least a portion of the bottommost layer of insulation covering and/or contacting at least a portion of the heat-conductive component. The insulation fabric, board, or foam may be made of polystyrene foam, urethane foam, fiberglass, ceramic wool, cellulose, cork, silicone rubber, perlite, vermiculite, or others known to the art.

This invention provides for faster manufacturing and repairs of ovens 1 and the systems using them. With the removal of a few fasteners, typically mechanical fasteners, such as nuts, bolts, screws and/or others, and one or more layers of thermal insulation, a faulty fan for example, or other faulty component, is easily accessed, repaired, and then the one or more layers of thermal insulation are reinstalled using the one or more fasteners and the oven 1 is ready for reuse after the necessary purge steps, if any.

The oven 1 also allows for the maximization of the uptime of all of the tools in a manufacturing facility supplied with the necessary gases and chemicals for manufacture from systems having the oven 1 as part of the system, and increased uptime of the systems having the oven 1. The oven 1 also minimizes the space required for supplying precursor materials, thereby allowing for increasing the numbers of other components (pipes, valves, manifolds, supply containers, and the like) in the same footprint. These and other benefits are provided by the oven 1.

## Claims

1. A heated enclosure (1) for optimized sublimation of solid-phase semiconductor process materials and subsequent delivery of the resultant vapor, the enclosure is an oven (1) approximately rectangular in shape, the enclosure comprising:
a hollow housing which is insulated to retain heat within the housing and has a top (8), a bottom (9), a pair of side walls each defined by a side exterior wall (16) and a corresponding side interior wall (17), a back interior wall (18) and a door, wherein the top (8), the bottom (9), the side walls, the back interior wall (18), and the door are provided with insulation;
at least two independent heated zones (10, 11) with independent temperature controls and dedicated overtemperature protection defining an upper heated zone (10) and a lower heated zone (11) and being located in the housing, the lower heated zone (11) configured to accept a container storing a solid-phase semiconductor process material;
a removable and height-adjustable rectangular divider plate (20) being made of an insulation material, separating the upper heated zone (10) and the lower heated zone (11), and minimizing heat transfer between the upper heated zone (10) and the lower heated zone (11) and the divider plate (20) is a substantially flat, smooth, relatively thin component made of a durable material capable of withstanding the elevated temperatures within both the upper heated zone (10) and the lower heated zone (11); and
a heat shield (27) affixed between a source of heating (12, 14) and the container; and
the source of heating (12, 14) comprising a first heater (12) providing heat to the upper heated zone (10) and a second heater (14) providing heat to the lower heated zone (11);
**characterized in that**
the divider plate (20) is sized to fit snugly within the heated enclosure (1), contacting and extending among the side interior walls (17), the back interior wall (18) and the door.

2. The heated enclosure (1) according to claim 1, further comprising guide rails (21) located in the housing and along which the divider plate (20) is inserted into and removed from the housing.

3. The heated enclosure (1) according to claim1, wherein the first heater (12) is affixed to the housing in the upper heated zone (10) and the second heater (14) is affixed to the housing in the lower heated zone (11).

4. The heated enclosure (1) according to any of the preceding claims, further comprising an attachment mechanism configured to retain the container within the housing.

5. The heated enclosure (1) according to claim 1, further comprising a scale chamber (40) located proximate the bottom (9) of the housing and a weighing scale (30) located within the scale chamber (40), the weighing scale (30) supporting and measuring the weight of the container and, therefore, allowing determination of the amount of the process material remaining in the container.

6. The heated enclosure (1) according to claim 5, wherein the oven has a footprint and the weighing scale (30) has an insulated scale platform (31) on which the container directly sits, the scale platform (31) being sized to accommodate almost the entire footprint of the oven to substantially insulate the scale chamber (40) from the upper heated zone (10) and the lower heated zone (11) located above the scale chamber (40).

7. The heated enclosure (1) according to claim 5, wherein the scale chamber (40) is ventilated.

8. The heated enclosure (1) according to claim 5, wherein a multiplicity of elevation rails (28) has been affixed to the scale platform (31).

9. The heated enclosure (1) according to claim 1, further comprising a circulation fan (50) located, and facilitating ventilation and air circulation, in the lower heated zone (11).

10. The heated enclosure (1) according to claim 1, further comprising an exhaust inlet (60) and a fresh air inlet (61) that, in combination, provide ventilation and fresh air to the upper heated zone (10).

11. The heated enclosure (1) according to claim 1, further comprising a pressure relief flap valve (70) that provides overpressure protection.

12. The heated enclosure (1) according to claim 1, further comprising at least one access port (75) configured to accommodate process piping, thermocouples, and other external structures.

13. The heated enclosure (1) according to claim 1, further comprising process piping disposed in an interconnect passthrough (80) formed in an opening in the housing, the process piping being in fluid communication between the container when located in the housing and an external delivery system to deliver process material from the container to the external delivery system.

14. A chemical delivery system comprising the heated enclosure (1) according to claim 1.

## Patentansprüche

1. Beheiztes Gehäuse (1) für eine optimierte Sublimation von Halbleiterprozessmaterialien in fester Phase und anschließende Abgabe des resultierenden Dampfes, wobei das Gehäuse ein Ofen (1) mit ungefähr rechteckiger Form ist, das Gehäuse umfassend:
eine hohle Umhüllung, welche isoliert ist, um die Wärme innerhalb der Umhüllung zu halten, und eine Oberseite (8), einen Boden (9), ein Paar Seitenwände, die jeweils durch eine seitliche Außenwand (16) und eine entsprechende seitliche Innenwand (17), eine hintere Innenwand (18) und eine Tür definiert sind, besitzt, wobei die Oberseite (8), der Boden (9), die Seitenwände, die hintere Innenwand (18) und die Tür mit einer Isolierung versehen sind;
mindestens zwei unabhängige beheizte Zonen (10, 11) mit unabhängigen Temperatursteuerungen und eigenem Übertemperaturschutz, die eine obere beheizte Zone (10) und eine untere beheizte Zone (11) definieren und in der Umhüllung angeordnet sind, wobei die untere beheizte Zone (11) so konfiguriert ist, dass sie einen Behälter aufnimmt, der ein Festphasen-Halbleiterprozessmaterial enthält;
eine abnehmbare und höhenverstellbare rechteckige Trennplatte (20), die aus einem Isoliermaterial besteht, welche die obere beheizte Zone (10) und die untere beheizte Zone (11) trennt und die Wärmeübertragung zwischen der oberen beheizten Zone (10) und der unteren beheizten Zone (11) minimiert, wobei die Trennplatte (20) ein im Wesentlichen flaches, glattes, relativ dünnes Bauteil ist, das aus einem haltbaren Material besteht, das in der Lage ist, den erhöhten Temperaturen sowohl in der oberen beheizten Zone (10) als auch in der unteren beheizten Zone (11) standzuhalten; und
einen Hitzeschild (27), der zwischen einer Heizquelle (12, 14) und dem Behälter befestigt ist; und
die Heizquelle (12, 14) umfassend ein erstes Heizelement (12), dass die obere beheizte Zone (10) mit Wärme versorgt, und ein zweites Heizelement (14), das die untere beheizte Zone (11) mit Wärme versorgt;
**dadurch gekennzeichnet, dass**
die Trennplatte (20) so bemessen ist, dass sie genau in das beheizte Gehäuse (1) passt und die seitlichen Innenwände (17), die hintere Innenwand (18) und die Tür berührt und sich zwischen ihnen erstreckt.

2. Das beheizte Gehäuse (1) nach Anspruch 1, ferner in der Umhüllung angeordnete Führungsschienen (21) umfassend, entlang derer die Trennplatte (20) in die Umhüllung eingesetzt und aus dieser entfernt wird.

3. Das beheizte Gehäuse (1) nach Anspruch 1, wobei das erste Heizelement (12) im oberen beheizten Bereich (10) an der Umhüllung befestigt ist und das zweite Heizelement (14) im unteren beheizten Bereich (11) an der Umhüllung befestigt ist.

4. Das beheizte Gehäuse (1) nach einem der vorhergehenden Ansprüche, ferner einen Befestigungsmechanismus umfassend, der so konfiguriert ist, dass er den Behälter innerhalb der Umhüllung festhält.

5. Das beheizte Gehäuse (1) nach Anspruch 1, ferner eine Waagenkammer (40), die sich in der Nähe des Bodens (9) der Umhüllung befindet, und eine Waage (30) umfassend, die sich in der Waagenkammer (40) befindet, wobei die Waage (30) das Gewicht des Behälters trägt und misst und daher die Bestimmung der im Behälter verbleibenden Menge des Prozessmaterials ermöglicht.

6. Das beheizte Gehäuse (1) nach Anspruch 5, wobei der Ofen eine Grundfläche hat und die Waage (30) eine isolierte Waagenplattform (31) hat, auf welcher der Behälter direkt steht, wobei die Waagenplattform (31) so bemessen ist, dass sie fast die gesamte Grundfläche des Ofens aufnimmt, um die Waagenkammer (40) von der oberen beheizten Zone (10) und der unteren beheizten Zone (11), die sich über der Waagenkammer (40) befindet, im Wesentlichen zu isolieren.

7. Das beheizte Gehäuse (1) nach Anspruch 5, wobei die Waagenkammer (40) belüftet ist.

8. Das beheizte Gehäuse (1) nach Anspruch 5, bei dem eine Vielzahl von Höhenschienen (28) an der Waagenplattform (31) befestigt ist.

9. Das beheizte Gehäuse (1) nach Anspruch 1, ferner ein Umwälzgebläse (50) umfassend, das in der unteren beheizten Zone (11) angeordnet ist und die Belüftung und Luftzirkulation ermöglicht.

10. Das beheizte Gehäuse (1) nach Anspruch 1 ferner einen Ablufteinlass (60) und einen Frischlufteinlass (61) umfassend, die in Kombination die obere beheizte Zone (10) belüften und mit Frischluft versorgen.

11. Das beheizte Gehäuse (1) nach Anspruch 1, ferner ein Druckentlastungsklappenventil (70) umfassend, das einen Überdruckschutz bietet.

12. Das beheizte Gehäuse (1) nach Anspruch 1, ferner mindestens eine Zugangsöffnung (75) umfassend, die so gestaltet ist, dass sie Prozessrohrleitungen, Thermoelemente und andere externe Strukturen aufnehmen kann.

13. Das beheizte Gehäuse (1) nach Anspruch 1, ferner Prozessrohrleitungen umfassend, die in einer Verbindungsdurchführung (80) angeordnet sind, die in einer Öffnung in der Umhüllung ausgebildet ist, wobei die Prozessrohrleitungen in Fluidverbindung zwischen dem Behälter, wenn er sich im Gehäuse befindet, und einem externen Abgabesystem stehen, um Prozessmaterial aus dem Behälter an das externe Abgabesystem zu liefern.

14. Ein chemisches Abgabesystem umfassend das beheizte Gehäuse (1) nach Anspruch 1.

## Revendications

1. Enceinte chauffée (1) pour la sublimation optimisée de matériaux de procédé semi-conducteur en phase solide et la distribution consécutive de la vapeur résultante, l'enceinte étant un four (1) de forme approximativement rectangulaire, l'enceinte comprenant :
un logement creux qui est isolé pour retenir la chaleur à l'intérieur du logement et comporte un sommet (8), un fond (9), une paire de parois latérales, chacune définie par une paroi latérale extérieure (16) et une paroi latérale intérieure correspondante (17), une paroi intérieure arrière (18) et une porte, le sommet (8), le fond (9), les parois latérales, la paroi intérieure arrière (18) et la porte étant dotés d'une isolation ;
au moins deux zones chauffées indépendantes (10, 11) avec des commandes de température indépendantes et une protection dédiée contre les températures excessives définissant une zone chauffée supérieure (10) et une zone chauffée inférieure (11) et étant situées dans le logement, la zone chauffée inférieure (11) étant conçue pour accueillir un récipient stockant un matériau de procédé semi-conducteur en phase solide ;
une plaque de séparation rectangulaire amovible et réglable en hauteur (20) constituée d'un matériau isolant, séparant la zone chauffée supérieure (10) et la zone chauffée inférieure (11), et minimisant le transfert de chaleur entre la zone chauffée supérieure (10) et la zone chauffée inférieure (11), la plaque de séparation (20) étant un composant sensiblement plat, lisse, relativement mince, constitué d'un matériau durable pouvant supporter les températures élevées à l'intérieur à la fois de la zone chauffée supérieure (10) et de la zone chauffée inférieure (11) ; et
un écran thermique (27) fixé entre une source de chauffage (12, 14) et le récipient ; et
la source de chauffage (12, 14) comprenant un premier dispositif de chauffage (12) fournissant de la chaleur à la zone chauffée supérieure (10) et un deuxième dispositif de chauffage (14) fournissant de la chaleur à la zone chauffée inférieure (11) ;
**caractérisée en ce que**
la plaque de séparation (20) est dimensionnée pour s'ajuster parfaitement à l'intérieur de l'enceinte chauffée (1), en contact avec et s'étendant entre les parois latérales intérieures (17), la paroi intérieure arrière (18) et la porte.

2. Enceinte chauffée (1) selon la revendication 1, comprenant en outre des rails de guidage (21) situés dans le logement et le long desquels la plaque de séparation (20) est insérée dans et retirée du logement.

3. Enceinte chauffée (1) selon la revendication 1, dans laquelle le premier dispositif de chauffage (12) est fixé au logement dans la zone chauffée supérieure (10) et le deuxième dispositif de chauffage (14) est fixé au logement dans la zone chauffée inférieure (11).

4. Enceinte chauffée (1) selon l'une quelconque des revendications précédentes, comprenant en outre un mécanisme de fixation conçu pour retenir le récipient à l'intérieur du logement.

5. Enceinte chauffée (1) selon la revendication 1, comprenant en outre une chambre de mesure (40) située à proximité du fond (9) du logement et une balance (30) située à l'intérieur de la chambre de mesure (40), la balance (30) supportant et mesurant le poids du récipient et, par conséquent, permettant la détermination de la quantité du matériau de procédé restant dans le récipient.

6. Enceinte chauffée (1) selon la revendication 5, dans laquelle le four présente une empreinte et la balance (30) comporte un plateau de balance isolé (31) sur lequel repose directement le récipient, le plateau de balance (31) étant dimensionné pour accueillir quasiment l'empreinte entière du four afin d'isoler en grande partie la chambre de mesure (40) de la zone chauffée supérieure (10) et de la zone chauffée inférieure (11) situées au-dessus de la chambre de mesure (40).

7. Enceinte chauffée (1) selon la revendication 5, dans laquelle la chambre de mesure (40) est ventilée.

8. Enceinte chauffée (1) selon la revendication 5, dans laquelle une multiplicité de rails élévateurs (28) a été fixée au plateau de balance (31).

9. Enceinte chauffée (1) selon la revendication 1, comprenant en outre un ventilateur de circulation (50) situé, et facilitant la ventilation et la circulation d'air, dans la zone chauffée inférieure (11).

10. Enceinte chauffée (1) selon la revendication 1, comprenant en outre une entrée d'échappement (60) et une entrée d'air frais (61) qui, combinées, fournissent ventilation et air frais à la zone chauffée supérieure (10).

11. Enceinte chauffée (1) selon la revendication 1, comprenant en outre un clapet de décharge (70) qui assure une protection contre les surpressions.

12. Enceinte chauffée (1) selon la revendication 1, comprenant en outre au moins un orifice d'accès (75) conçu pour accueillir de la tuyauterie de procédé, des thermocouples, et d'autres structures externes.

13. Enceinte chauffée (1) selon la revendication 1, comprenant en outre de la tuyauterie de procédé disposée dans une traversée d'interconnexion (80) formée dans une ouverture dans le logement, la tuyauterie de procédé étant en communication fluidique entre le récipient quand il se trouve dans le logement et un système de distribution externe pour distribuer un matériau de procédé depuis le récipient au système de distribution externe.

14. Système de distribution de produits chimiques comprenant une enceinte chauffée (1) selon la revendication 1.
